# EUROPÄISCHE PATENTSCHRIFT

(11) **EP 1 507 708 B1**
(45) Veröffentlichungstag und Bekanntmachung des Hinweises auf die Patenterteilung: **27.07.2005**
(21) Anmeldenummer: 03746807.1
(22) Anmeldetag: 16.04.2003
(51) Int. Cl.: B65B 15/04, B65B 9/02, H05K 13/00

(54) **VERPACKUNGSANLAGE UND VERFAHREN ZUM BESTÜCKEN EINES TRAGGURTES MIT ELEKTRONISCHEN BAUTEILEN**
PACKAGING DEVICE AND METHOD FOR FITTING A CARRIER BELT WITH ELECTRONIC COMPONENTS
DISPOSITIF D'EMBALLAGE ET PROCEDE D'IMPLANTATION DE COMPOSANTS ELECTRONIQUES SUR UNE BANDE SUPPORT

(30) Priorität: 20.04.2002 DE 10217792
(43) Veröffentlichungstag der Anmeldung: 23.02.2005
(73) Patentinhaber: Infineon Technologies AG, 81669 München (DE)
(72) Erfinder: NEUHOFF, Oskar, 93152 Nittendorf (DE); ROIDER, Peter, 93092 Barbing (DE)
(74) Vertreter: Schäfer, Horst, Dr.
(86) Internationale Anmeldenummer: PCT/DE2003/001278
(87) Internationale Veröffentlichungsnummer: WO 2003/089305

(56) Entgegenhaltungen:
- US-A- 3 724 068
- US-A- 4 406 367
- US-A- 5 203 143

## Beschreibung

Die Erfindung betrifft eine Verpackungsanlage mit einem Werkzeug zum Einschließen elektronischer Bauteile in einen Traggurt und ein Verfahren zum Bestücken des Traggurtes.

Elektronische Bauteile werden zum Transport und zur Anlieferung an einen Bestückungsautomaten oftmals in sog. Trag- oder Transportgurte eingeschlossen, die im aufgerollten Zustand gelagert und transportiert werden können. Derartige Transportgurte weisen vorgeformte Gurttaschen auf, in denen elektronische Bauteile lagegetreu angeordnet und transportiert werden können, sowie lagegetreu den Transportgurten entnommen werden können. Zum Transport werden die Gurttaschen eines Transportgurtes mit Hilfe eines Abdeckgurtbandes abgedeckt, so dass die elektronischen Bauteile nicht aus den Gurttaschen herausfallen können und ihre Lage in Bezug auf die drei Raumachsen bis zur Entnahme aus den Transportgurten nicht ändern.

Dazu ist aus der Druckschrift US-A-5 203 143 ein Verfahren bekannt, bei dem die Bauteile von oben in Öffnungen eines Traggurts eingelegt werden, wobei die Öffnungen an ihrer Unterseite mit zwei Klebestreifen teilweise geschlossen sind. Die Bauteile werden durch die Klebestreifen in den Öffnungen des Traggurts gehalten.

Beim Einbringen und Positionieren insbesondere von kleinen und/oder leichten elektronischen Bauteilen und/oder Halbleiterchips, wie sie in großer Stückzahl für die integrierte Schaltungstechnik, die Leucht- und Lasertechnik und dgl. benötigt werden, ist ein schnelles Bestücken bei hoher Durchsatzrate mit der Gefahr verbunden, dass die Bauteile aus den bekannten Gurttaschenöffnungen herausspringen und damit den Bestückungsvorgang eines Bestückungsautomaten für Transportgurte erheblich behindern, zumal nicht nur die Bestückung zu unterbrechen ist, sondern der Automat gründlich nach den heraus gesprungenen elektronischen Bauteilen abzusuchen und die Bestückungsposition des Automaten neu zu definieren und einzujustieren ist.

Ein weiteres Problem bei der Bestückung von Transportgurten mit kleinen und/oder leichten elektronischen Bauteilen im Millimeterbereich ist darin zu sehen, dass die Präzisionsanforderungen sowohl an die Formgebung der Gurttaschen als auch an den Bestückungsautomaten ständig steigende Investitions- und Entwicklungskosten erfordern, um die elektronischen Bauteile präzise und lagegetreu in den Gurttaschen zu positionieren und um diesen Präzisionsanforderungen zu genügen.

Elektronische Bauteile werden mittels eines Drehkreuzes oder eines Schwenkarms in die Taschen des Transportgurtes eingelegt. Die elektronischen Bauteile sind zu diesen Zeitpunkt auf dem Wafer bzw. auf dem Nutzen bereits soweit vereinzelt, dass sie von einer Trägerfolie abgelöst und vom Schwenkarm aufgenommen werden können. Alle die beschriebenen Verfahren benötigen einen relativ hohen Handhabungsaufwand und sind daher mit gewissen minimalen Taktzeiten verbunden.

Aufnahmevorrichtungen zur Handhabung und Positionierung von Halbleiterchips an ihrem vorgesehen Einbauort sind aus der JP 100 84 005 A, aus der JP 100 84 006 A sowie aus der JP 100 84 032 A bekannt. Eine Vorrichtung zur Positionierung von Halbleiterchips ist weiterhin aus der JP 061 51 483 A bekannt.

Ein Ziel der Erfindung besteht darin, eine Vorrichtung und ein Verfahren zum Bestücken von Transportgurten mit elektronischen Bauteilen oder Halbleiterchips zur Verfügung zu stellen, mit denen eine schnelle, zuverlässige und präzise Bestückung mit elektronischen Bauteilen von Transportgurten wie Papiergurten mit doppelseitiger Folienabdeckung oder Blistergurten mit einseitiger Folienabdeckung möglich ist.

Dieses Ziel der Erfindung wird mit dem Gegenstand der unabhängigen Ansprüche erreicht. Merkmale vorteilhafter Weiterbildungen der Erfindung ergeben sich aus den jeweiligen abhängigen Ansprüchen.

Gemäß der Erfindung ist eine Verpackungsanlage mit einer Führungsplatte zur linearen Führung eines mit elektronischen Bauteilen oder mit Halbleiterchips bestückbaren Traggurtes vorgesehen. Die Führung kann gleitend horizontal erfolgen, Die Führungsplatte weist eine Durchgangsöffnung auf.

Die Verpackungsanlage verfügt über ein Traggurtbestückungswerkzeug, das eine Vakuumpipette und eine Hubnadel aufweist, die auch allgemein als Hubeinrichtung ausgebildet sein kann. Die Vakuumpipette ist dabei insbesondere so ausgeführt, dass sie jeweils ein elektronisches Bauteil oder jeweils einen Halbleiterchip von oben aufnehmen kann. Die Hubnadel kann so ausgebildet sein, dass sie das elektronische Bauteil oder den Halbleiterchip von unten führt.

Die Vakuumpipette und die Hubnadel sind zum senkrechten Abnehmen jeweils eines auf einer Trägerfolie bzw. Trägerplatte bereitgestellten elektronischen Bauteils oder Halbleiterchips und zum Positionieren des jeweils abgenommenen elektronischen Bauteils bzw. Halbleiterchips in jeweils einer Kavität bzw. einer Durchgangsöffnung eines Traggurts bestimmt. Dabei können die Vakuumpipette und/oder die Hubnadel jeweils eine Hubbewegung ausführen und sich in und/oder durch die Durchgangsöffnung der Führungsplatte bewegen.

Die Bauteile werden von der Vakuumpipette abgestreift, und zwar insbesondere durch die Bewegung des Traggurts in Transportrichtung.

Die Verpackungsanlage umfasst ferner wenigstens eine obere Abdeckfolienvorrichtung zum Aufbringen einer oberen Abdeckfolie und/oder eine untere Abdeckfolienvorrichtung zum Aufbringen einer unteren Abdeckfolie auf den Traggurt.

Gemäß einer anderen Darstellung der Erfindung umfasst die erfindungsgemäße Verpackungsanlage ein Werkzeug zum Einlegen elektronischer Bauteile in einen Traggurt, der Durchgangsöffnungen zur Aufnahme einzelner elektronischer Bauteile aufweist. Das Werkzeug weist eine Aufnahmevorrichtung mit einer Vakuumpipette und eine Hubnadel auf zur senkrechten Abnahme der elektronischen Bauteile von einer Trägerfolie bzw. Trägerplatte und zur Positionierung der Bauteile in den Durchgangsöffnungen mittels einer Hubbewegung der Vakuumpinzette. Der Traggurt ist in horizontaler Transportrichtung derart geführt, dass er die Bauteile von der Vakuumpipette in Transportrichtung abstreift. Die Verpackungsanlage weist weiterhin eine Führungsplatte zur linearen gleitenden horizontalen Förderung des mit elektronischen Bauteilen bestückten Traggurts sowie jeweils Vorrichtungen zum Aufbringen einer oberen und einer unteren Abdeckfolie auf den Traggurt auf.

Diese erfindungsgemäße Verpackungsanlage weist den Vorteil einer nur minimalen Handhabungsbewegung zur Aufnahme und Übergabe von auf einem Nutzen befindlichen elektronischen Bauteilen in einen Traggurt auf. Die Bauteile müssen lediglich mittels einer linearen Hubbewegung nach oben geschoben werden, so dass keinerlei aufwendige Handhabungsschritte oder Verfahrensschritte der Vakuumpipette notwendig sind. Auch für die Abnahme der elektronischen Bauteile von der Vakuumpipette sind keine zusätzlichen Werkzeuge oder Hilfsmittel erforderlich, da diese Aufgabe von dem zu bestückenden Traggurt übernommen wird. Das Abstreifen des elektronischen Bauteils von der Vakuumpipette durch den Traggurt ist ein das elektronische Bauteil schonender Vorgang. Durch den Einsatz einer Vakuumpipette, die eine zentrale während des Hubvorgangs und während des Abstreifvorgangs evakuierte Kapillare aufweist, wird das Bauteil und insbesondere die Bauteiloberseite schonend behandelt. Dazu besitzt die Vakuumpipette an ihrer Spitze eine hochpolierte minimale Andruckfläche, auf welche die Bauteiloberseite gepresst wird. Diese Andruckfläche kann zu einer Teflonspitze gehören, die entsprechend nachgiebig ist, und die Bauteiloberseite nicht beschädigt. Bei metallischen Vakuumpipetten kann die Andruckfläche zusätzlich gehärtet sein, um lange Standzeiten zu erreichen. Ein solches Härten kann durch Diffusionshärten erfolgen, wodurch keine zusätzliche Oberflächenschicht aufgebaut wird. Bei einem sog. "Kolsterisieren" werden Härten von ca. 1200 bis 1300 Vickers erreicht, ohne dass zusätzlich Material aufgetragen wird.

Ein weiterer Vorteil der Vakuumpipette mit ihrer hochpolierten minimalen Andruckfläche ist, dass eine geringe Vakuumleistung ausreicht, um dem Bauteil mit der evakuierten Kapillare zu halten. Darüber hinaus ist eine Einjustasche und Anpassung der Vakuumpipette an die Dicke sowohl der Bauteile als auch die Dicke der Traggurte mit einfachen Mitteln möglich.

Gemäß einer erfindungsgemäßen Ausführungsform ist die Aufnahmevorrichtung eine Vakuumpipette, die eine schonende und sichere Handhabung der elektronischen Bauteile ermöglicht. Gemäß einer weiteren Ausführungsform der Erfindung weist die Vakuumpipette eine Hubrichtung senkrecht zur Förderrichtung des Traggurts und durch dessen Durchgangsöffnungen hindurch auf. Ebenso wie die Vakuumpipette weist vorzugsweise auch die Hubnadel eine Hubrichtung senkrecht zur Förderrichtung des Traggurts und bis zum unteren Rand von dessen Durchgangsöffnungen auf. Die nur minimalen Hubbewegungen der Vakuumpipette sowie der Hubnadel stellen eine exakte Positionierung und Ablage der elektronischen Bauteile im Traggurt sicher. Dabei sind die Hubbewegungen der Hubnadel gemäß einer bevorzugten Ausführungsform der Erfindung mit den Hubbewegungen der Vakuumpipette synchronisiert und das Vakuum wird solange beibehalten, bis der sich fortbewegende Transportgurt das elektronische Bauteil von dem Mundstück der Vakuumpipette abgestreift hat.

Eine alternative Ausführungsform der Erfindung sieht vor, dass zumindest die Vakuumpipette beim Einlegen eines elektronischen Bauteils in eine Durchgangsöffnung eine waagrechte Bewegungskomponente in gleiche Richtung wie die Förderrichtung des Traggurts aufweist. Diese waagrechte Bewegungskomponente der Vakuumpipette verhindert zuverlässig das Herausfallen der elektronischen Bauteile nach unten nach dem Aufheben des Vakuums.

Die elektronischen Bauteile können besonders einfach aufgenommen und im Traggurt abgelegt werden, wenn sie in Zeilen und/oder Spalten auf einem Bauteilträger bzw. einem Nutzen aufgebracht und durch eine Trägerfolie zusammen gehalten sind.

Der Bauteilträger bzw. der Nutzen mit der Trägerfolie ist gemäß einer weiteren erfindungsgemäßen Ausführungsform auf einem horizontal verschiebbaren Ablagetisch aufgebracht, wodurch ein schnelles und genaues Verschieben und Positionieren der elektronischen Bauteile unterhalb des Traggurts erleichtert wird. Zu diesem Zweck ist der Ablagetisch vorzugsweise in einer ersten horizontalen Richtung parallel zur Förderrichtung des Traggurts sowie in einer zweiten horizontalen Richtung senkrecht dazu verschiebbar.

Um die elektronischen Bauteile problemlos vom Nutzen bzw. der Trägerfolie ablösen zu können, weist der Ablagetisch eine zweite Öffnung größeren Durchmessers als die Hubnadel auf, die jeweils in eine senkrecht unterhalb einer Durchgangsöffnung des Traggurts befindliche Position bringbar ist. Die Hubnadel kann durch diese Öffnung hindurch geschoben werden und kann zusammen mit der Vakuumpipette das jeweilige elektronische Bauteil in den Traggurt fördern.

Vorzugsweise weist die Führungsplatte eine erste Öffnung größeren Durchmessers als eine Grundfläche eines elektronischen Bauteils auf, durch die sich mittig die linearen Hubachsen der Vakuumpipette sowie der Hubnadel erstrecken. Direkt oberhalb dieser ersten Öffnung befindet sich die Durchgangsöffnung des Traggurts, in die jeweils ein elektronisches Bauteil abgelegt wird.

Gemäß einer weiteren Ausführungsform der Erfindung weist die Verpackungsanlage in Förderrichtung des Traggurts hinter der Aufnahmevorrichtung Zuführvorrichtungen für die untere Abdeckfolie sowie für die obere Abdeckfolie auf. Diese werden mittels Umlenkrollen sowie jeweils einer Anpressvorrichtung auf die Gurtunter- bzw. -oberseite gedrückt und werden mit dieser verbunden. Dies kann bspw. mittels einer Heizvorrichtung oder auch durch Kleben erfolgen. Die Zuführvorrichtung für die obere Abdeckfolie ist in Förderrichtung des Traggurts hinter der Zuführvorrichtung für die untere Abdeckfolie angeordnet.

Damit die elektronischen Bauteile beim Aufbringen der unteren Abdeckfolie nicht durch deren Zuführschlitz in der Führungsplatte fallen können, ist oberhalb der Zuführvorrichtung für die untere Abdeckfolie eine Vakuumsaugvorrichtung vorgesehen, mittels derer die elektronischen Bauteile in den Durchgangsöffnungen gehalten werden.

Ein erfindungsgemäßes Verfahren zum Bestücken eines Traggurts mit elektronischen Bauteilen weist folgende Schritte auf. Es wird ein Traggurt mit Durchgangsöffnungen für eine Verpackungsanlage zum Bestücken mit elektronischen Bauteilen bereit gestellt. Mittels einer Vakuumpipette werden einzelne elektronische Bauteile von einem unterhalb der Förderplatte der Verpackungsanlage angeordneten Ablagetisch aufgenommen. Jeweils ein elektronisches Bauteil wird in jede Durchgangsöffnung des Traggurts mittels einer senkrechten Hubbewegung der das elektronische Bauteil hebenden Vakuumpipette eingebracht. Anschließend wird das elektronische Bauteil mit Hilfe des Traggurtes von der Vakuumpipette abgestreift. Eine Gurtoberseite wird durch Aufbringen einer oberen Abdeckfolie verschlossen. In gleicher Weise wird eine Gurtunterseite durch Aufbringen einer unteren Abdeckfolie verschlossen.

Dieses Verfahren hat den Vorteil, dass das elektronische Bauteil äußerst schonend in die Durchgangsöffnungen bzw. Kavitäten des Traggurtes übergeben wird, da die Andruckfläche der Vakuumpipette äußerst gering ist und das Abstreifen des elektronischen Bauteils in horizontaler Richtung von dieser Andruckfläche keine Belastung für das elektronische Bauteil darstellt.

Eine erfindungsgemäße Ausgestaltung des Verfahrens sieht vor, dass die elektronischen Bauteile von oben mit einer Vakuumpipette und von unten mit einer Hubnadel aufgenommen werden, was eine exakte Ablage der Bauteile im Traggurt ermöglicht. Vorzugsweise führen die Vakuumpipette und die Hubnadel eine senkrechte Hubbewegung durch eine erste Öffnung der Führungsplatte aus, während der Transportgurt quer dazu bewegt wird und das elektronische Bauteil von der Vakuumpipette in Transportrichtung abstreift.

Eine alternative Ausführungsform des erfindungsgemäßen Verfahrens sieht vor, dass zumindest die Vakuumpipette beim Einlegen des elektronischen Bauteils in eine Durchgangsöffnung des Traggurts eine waagrechte Bewegung mit dessen Förderrichtung ausführt, wodurch die elektronischen Bauteile zuverlässig am Herausfallen nach unten durch die erste Öffnung nach dem Abschalten des Vakuums der Vakuumpipette gehindert werden.

Die untere Abdeckfolie wird durch einen Zuführschlitz in der Führungsplatte von unten her auf den Traggurt aufgebracht. Damit die elektronischen Bauteile nicht durch diesen Zuführschlitz heraus fallen können, ist oberhalb der Zuführvorrichtung für die untere Abdeckfolie eine Vakuumsaugvorrichtung vorgesehen.

Die obere und untere Abdeckfolie können jeweils mittels einer Heizvorrichtung auf die Gurtoberseite bzw. -unterseite haftend aufgebracht werden. Alternativ können die Abdeckfolien auch mit dem Traggurt verklebt werden. Als Traggurt kommt vorzugsweise ein Papiergurt zum Einsatz. Die Abdeckfolien sind vorzugsweise aus thermoplastischem Kunststoff bzw. ebenfalls aus Papier.

Die Erfindung wird nun anhand von Ausführungsformen mit Bezug auf die beiliegenden Figuren näher erläutert.
- Figur 1: zeigt eine Schemadarstellung einer erfindungsgemäßen Verpackungsanlage mit einem Werkzeug zum Einlegen elektronischer Bauteile in einen Traggurt.
- Figur 2: zeigt einen Detailausschnitt der Verpackungsanlage entsprechend Figur 1.
- Figur 3: zeigt eine Prinzipskizze der Aufnahmevorrichtung einer weiteren Ausführungsform der Erfindung.

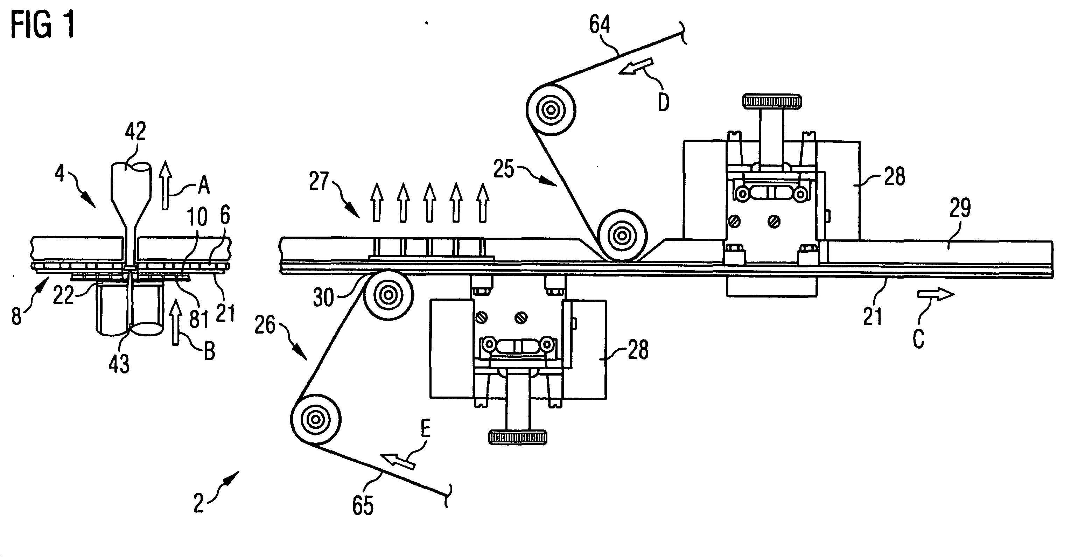

Figur 1 zeigt einen schematischen Querschnitt einer erfindungsgemäßen Verpackungsanlage 2 mit einem Werkzeug 4 zum Einlegen elektronischer Bauteile 10 in einen Traggurt 6. Das Werkzeug 4 umfasst eine Aufnahmevorrichtung 41 zur Aufnahme und Übergabe der auf einem Nutzen 8 gruppierten elektronischen Bauteile 10. Mittels der Aufnahmevorrichtung 41, die im Wesentlichen eine Vakuumpipette 42 sowie eine Hubnadel 43 umfasst, werden einzelne elektronische Bauteile 10 von einer Trägerfolie 81 des Nutzens 8 abgelöst und in Durchgangsöffnungen 63 des Traggurts 6 platziert.

Der Traggurt 6 besteht vorzugsweise aus Papier und wird gleitend auf einer Führungsplatte 21 aus Metall gefördert. Die Führungsplatte 21 erstreckt sich über eine ausreichende Länge, dass in Förderrichtung C hinter dem Werkzeug 4 ausreichend Platz bleibt, um eine obere Abdeckfolie 64 auf eine Gurtoberseite 61 sowie eine untere Abdeckfolie 65 auf eine Gurtunterseite 62 aufzubringen. Zu diesem Zweck ist eine Zuführvorrichtung 26 für die untere Abdeckfolie 65 an der Unterseite der Führungsplatte 21 vorgesehen, mittels derer die untere Abdeckfolie 65 über mehrere Umlenkrollen an die Gurtunterseite 62 herangeführt wird (Förderrichtung E).

Oberhalb der Zuführvorrichtung 26 für die untere Abdeckfolie 65 ist eine Vakuumsaugvorrichtung 27 vorgesehen, durch die die in den Durchgangsöffnungen 63 des Traggurts 6 liegenden und von diesem auf der Führungsplatte 21 entlang geschobenen elektronischen Bauteile 10 nach oben an eine Führungsabdeckung 29 der Führungsplatte 21 gesaugt und am Herausfallen nach unten aus einem Zuführschlitz 30 für die untere Abdeckfolie 65 gehindert werden.

In Förderrichtung C des Traggurts 6 hinter der Zuführvorrichtung 26 für die untere Abdeckfolie 65 ist eine Zuführvorrichtung 25 für eine obere Abdeckfolie 64 angeordnet, mittels derer die obere Abdeckfolie 64 über mehrere Umlenkrollen an die Gurtoberseite 61 herangeführt wird (Förderrichtung D). Mittels Heizvorrichtungen 28 werden die obere bzw. untere Abdeckfolie 64, 65 fest haftend mit dem Traggurt 6 verbunden. Mittels der Abdeckfolien 64, 65 werden die elektronischen Bauteile 10 daran gehindert, aus den Durchgangsöffnungen 63 des Traggurts 6 zu fallen. Die Abdeckfolien 64, 65 bestehen vorzugsweise aus einem thermoplastischen Kunststoff und werden mittels der Heizvorrichtungen 28 punktuell aufgeschmolzen und mit dem Traggurt 6 aus Papier verbunden. Alternativ können statt der Heizvorrichtungen 28 auch Möglichkeiten vorgesehen werden, die Abdeckfolien 64, 65 mittels Klebeverbindungen mit dem Traggurt 6 zu verbinden.

Der Traggurt 6 kann nach dem Bestücken mit den elektronischen Bauteilen 10 auf eine Rolle aufgewickelt werden, womit er sich zum Transport und zur Anlieferung an eine Montagelinie eignet.

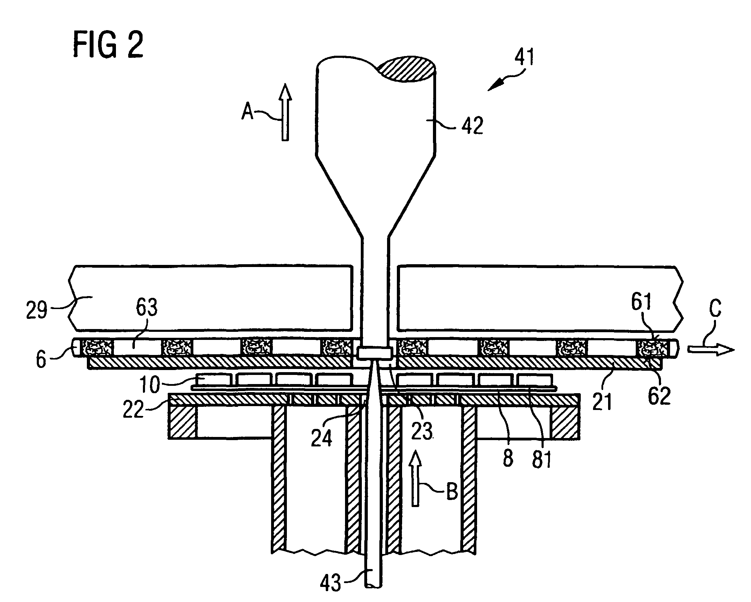

Figur 2 zeigt in einem schematischen Querschnitt einen Detailausschnitt der Verpackungsanlage 2 entsprechend Figur 1. Hierbei wird die Aufnahme und Übergabe der elektronischen Bauteile 10 vom Nutzen 8 in den Traggurt 6 verdeutlicht.

Der Nutzen 8 umfasst eine Trägerfolie 81, auf der die elektronischen Bauteile 10 in Zeilen und Spalten haftend angebracht sind. Die Trägerfolie 81 liegt mit ihrer Unterseite auf einem Ablagetisch 22, der in horizontaler Richtung verschoben werden kann. Der Ablagetisch 22 kann vorzugsweise in Förderrichtung C des Traggurts 6 sowie senkrecht dazu verschoben werden. Mittig im Ablagetisch 22, dem sogenannten Vakuumpilz, ist eine zweite Durchgangsöffnung 24 vorgesehen, durch die eine Hubnadel 43 senkrecht nach oben (Hubrichtung B) geschoben werden kann. Während das Bauteil abgehoben wird, wird Vakuum an den Vakuumpilz angelegt, um die Klebefolie 81 an dem Vakuumpilz zu halten.

Der Ablagetisch 22 befindet sich unmittelbar unterhalb der Führungsplatte 21, so dass ein elektronisches Bauteil 10 mittels der Aufnahmevorrichtung 41 des Werkzeugs 4 direkt vom Nutzen 81 in eine Durchgangsöffnung 63 des Traggurts 6 befördert und dort abgelegt werden kann. Zu diesem Zweck kann die Vakuumpipette 42 durch eine erste Öffnung 23 in der Führungsplatte 21 durch diese hindurch nach unten - entgegen der Hubrichtung A - geschoben und auf eine Oberseite eines elektronischen Bauteils 10 gesetzt werden. Gleichzeitig wird die Hubnadel 43 von unten an die Trägerfolie 81 gedrückt. Durch eine simultane Hubbewegung der Hubnadel 43 sowie der Vakuumpipette (Hubrichtungen A, B) wird das elektronische Bauteil 10 von der Trägerfolie 81 des Nutzens 8 abgehoben, wobei die Hubnadel 43 die Trägerfolie 81 durchstößt.

Die Aufnahmevorrichtung 41 wird senkrecht nach oben verfahren, bis das elektronische Bauteil 10 in der Durchgangsöffnung 63 des Traggurts 6 positioniert ist. Der Traggurt 6 wird auf der Führungsplatte 21 nach rechts in Förderrichtung C verschoben, wobei gleichzeitig die in den jeweiligen Durchgangsöffnungen 63 befindlichen elektronischen Bauteile 10 auf der Führungsplatte 21 verschoben werden. Oberhalb der Führungsplatte 21 und beabstandet zu dieser ist eine Führungsabdeckung 29 vorgesehen. Zwischen dieser und der Führungsplatte 21 wird der Traggurt 6 entlang gezogen.

Um das elektronische Bauteil 10 nach dem Absetzen der Hubnadel 43 am Herausfallen nach unten durch die erste Öffnung 23 in der Führungsplatte 21 zu hindern, hält die Vakuumpipette 42 das elektronische Bauteil 10, bis die Hubnadel 43 zurückgefahren ist und durch den Gurtvorschub das Bauteil von der Vakuumpipette abgestreift ist. Um eine nochmals erhöhte Sicherheit gegen ein solches Herausfallen zu bieten, kann in einer Variante vorgesehen sein, dass die Vakuumpipette 42 nicht nur eine senkrechte Hubbewegung in Hubrichtung A, sondern auch eine geringfügige waagrechte Bewegung in Förderrichtung C des Traggurts 6 ausführt, bis das elektronische Bauteil 10 sicher auf der Führungsplatte 21 aufliegt und auf dieser entlang gleitet.

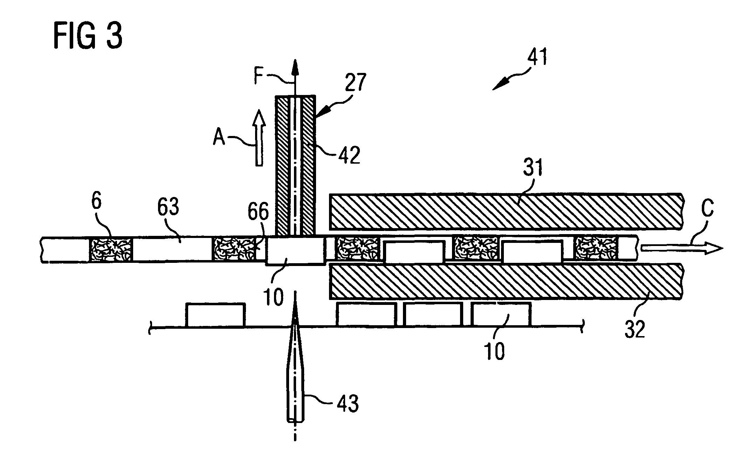

Figur 3 zeigt eine Prinzipsskizze der Aufnahmevorrichtung 41 einer weiteren Ausführungsform der Erfindung. Komponenten mit gleichen Funktionen wie in den vorhergehenden Figuren werden mit gleichen Bezugszeichen gekennzeichnet.

Der Traggurt 6 ist mit seinen Durchgangsöffnungen 63 bzw. Kavitäten zwischen einer oberen Führung 31 und einer unteren Führung 32 angeordnet. Unterhalb der unteren Führung ist eine Folie mit elektronischen Bauteilen 10 angebracht. Diese Folie wird von der Hubnadel 43 durchstoßen, um ein Bauteil 10 anzuheben und an eine Vakuumpipette 42 zu übergeben.

Dabei wird die untere Öffnung der Vakuumpipette 42 vom Bauteil 10 abgedeckt. Ein durch eine in dieser Ansicht nicht gezeigte Vakuumpumpe erzeugter Luftstrom wird unterbrochen und es entsteht ein Vakuum im inneren Kanal der Vakuumpipette 42. Durch den dabei aufgebauten Druckunterschied zwischen dem inneren Kanal der Vakuumpipette 42 und der Außenseite der Vakuumpipette 42 wird das Bauteil 10 an die Vakuumpipette 42 gedrückt. Dabei ist ein in dieser Ansicht nicht gezeigter Drucksensor am inneren Kanal der Vakuumpipette 42 vorgesehen, durch den einer in dieser Ansicht nicht gezeigten Steuerung mitgeteilt wird, ob sich ein Bauteil 10 an der unteren Öffnung der Vakuumpipette 42 befindet oder nicht. Zusätzlich zum Drucksensor oder auch alternativ dazu kann ein Luftflusssensor vorgesehen sein, der detektiert, ob mehr als eine Mindestmenge Luft durch den inneren Kanal der Vakuumpipette 42 strömt. Falls das der Fall ist, befindet sich kein Bauteil an der unteren Öffnung der Vakuumpipette 42.

Das Vakuum im inneren Kanal der Vakuumpipette 42 wird gerade so groß eingestellt, dass das Bauteil 10 an der unteren Öffnung der Vakuumpipette 42 gehalten wird und nicht davon abfällt.

Die Vakuumpipette 42 hebt das elektronische Bauteil 10 in die Kavität bzw. Durchgangsöffnung 63 des Traggurtes 6. Ein Gurtrand 66 nimmt das elektronische Bauteil beim horizontalen Durchziehen des Gurtes 6 zwischen der oberen Führung 31 und der unteren Führung 32 mit und streift es von der Vakuumpipette schonend ab. Aufgrund der geringen Haltekraft des minimierten Vakuums in der Vakuumpipette 42 braucht dabei nur eine geringe Reibkraft überwunden werden. Dabei wird das elektronische Bauteil 10 solange durch Vakuumabsaugung in Pfeilrichtung F von der Vakuumpipettenspitze gehalten, bis die untere Öffnung der Vakuumpipette 42 teilweise freigibt. In diesem Moment wird es von den Führungen 31 und 32 aufgenommen und geführt.

## Patentansprüche

1. Verfahren zum Bestücken eines Traggurts mit Bauteilen, das folgende Schritte aufweist:
- Bereitstellen eines Traggurts (6) mit Durchgangsöffnungen (63) für eine Verpackungsanlage (2) zum Bestücken des Traggurts (6) mit Bauteilen (10),
- Aufnehmen einzelner Bauteile (10) von einem unterhalb einer Führungsplatte (21) der Verpackungsanlage (2) angeordneten Ablagetisch (22) mittels einer Vakuumpipette (42), indem die Vakuumpipette (42) durch die Durchgangsöffnung (63) des Traggurtes (6) bewegt wird,
- Heben des Bauteils (10) in eine der Durchgangsöffnungen (63) des Traggurts (6) mittels einer senkrechten Hubbewegung der Vakuumpipette (42),
- Abstreifen des Bauteils (10) von der Vakuumpipette (42) mittels des Traggurtes (6), durch eine Bewegung des Traggurtes (6) in einer horizontale Förderrichtung (C),
- Aufnehmen des Bauteils (10) und des Traggurts (6) zwischen der Führungsplatte (21) und der oberhalb des Traggurtes (6) angeordneten Führungsabdeckung (29) beim Abstreifen von der Vakuumpipette (42) mittels einer oberen Führung (31) der Führungsabdeckung (29) und einer unteren Führung (32) der Führungsplatte (21),
- Verschließen einer Gurtoberseite (61) durch Aufbringen einer oberen Abdeckfolie (64),
- Verschließen einer Gurtunterseite (62) durch Aufbringen einer unteren Abdeckfolie (65).

2. Verfahren nach Anspruch 1,
**dadurch gekennzeichnet, dass**
die Bauteile (10) von unten mit einer Hubnadel (43) angehoben werden.

3. Verfahren nach Anspruch 1 oder 2,
**dadurch gekennzeichnet, dass**
die Vakuumpipette (42) und die Hubnadel (43) eine senkrechte Hubbewegung durch eine erste Öffnung (23) der Führungsplatte (21) hindurch ausführen.

4. Verfahren nach einem der Ansprüche 1 bis 3,
**dadurch gekennzeichnet, dass**
zumindest die Vakuumpipette (42) beim Einlegen eines Bauteils (10) in eine Durchgangsöffnung (63) des Traggurts (6) eine waagrechte Bewegung mit dessen Förderrichtung (C) ausführt.

5. Verfahren nach einem der Ansprüche 1 bis 4,
**dadurch gekennzeichnet, dass**
die untere Abdeckfolie (65) unterhalb einer Vakuumsaugvorrichtung (27) aufgebracht wird, welche die Bauteile (10) am Herausfallen aus den Durchgangsöffnungen (63) des Traggurts (6) nach unten hindert.

6. Verfahren nach einem der Ansprüche 1 bis 5,
**dadurch gekennzeichnet, dass**
die obere und untere Abdeckfolie (64, 65) mittels einer Heizvorrichtung (28) haftend auf die Gurtoberseite (61) bzw. auf die Gurtunterseite (62) angebracht werden.

7. Verfahren nach einem der Ansprüche 1 bis 6,
**dadurch gekennzeichnet, dass**
die obere und die untere Abdeckfolie (64, 65) mit der Gurtober- bzw. -unterseite (61 bzw. 62) verklebt werden.

8. Verfahren nach einem der Ansprüche 1 bis 8,
**dadurch gekennzeichnet, dass**
als Traggurt (6) ein Papiergurt eingesetzt wird, der Durchgangsöffnungen (63) zur Aufnahme von Bauteilen (10) aufweist.

9. Verpackungsanlage mit einer Führungsplatte (21), die eine untere Führung (32) aufweist, und mit einer Führungsabdeckung (29), die eine obere Führung (31) aufweist, zur linearen Führung eines mit Bauteilen (10) bestückbaren Traggurtes (6), und mit einem unterhalb der Führungsplatte (21) angeordneten Ablagetisch (22) für zu verpackende Halbleiterchips oder Halbleiterbauteile, wobei in der Führungsplatte (21) und der Führungsabdeckung (29) eine Durchgangsöffnung (23) vorgesehen ist und wobei
- die Verpackungsanlage (2) ein Traggurtbestückungswerkzeug (4) mit einer Vakuumpipette (42) und einer Hubnadel (43) aufweist,
- die Vakuumpipette (42) und/oder durch die Hubnadel (43) jeweils eine Hubbewegung ausführbar ist,
- die Hubnadel (43) und/oder die Vakuumpipette (42) in und/oder durch die Durchgangsöffnung (23) der Führungsplatte (21) bewegbar ist,
- wobei die Vakuumpipette (42) eine Hubbewegung durch die Durchgangsöffnung (23) der Führungsplatte (21) ausführen kann, und
wobei die Verpackungsanlage (2) ferner wenigstens eine obere Abdeckfolienvorrichtung zum Aufbringen einer oberen Abdeckfolie (64) und/oder eine untere Abdeckfolienvorrichtung zum Aufbringen einer unteren Abdeckfolie (65) aufweist.

10. Verpackungsanlage nach Anspruch 9,
**dadurch gekennzeichnet, dass**
die Vakuumpipette (42) eine Hubrichtung senkrecht zur Förderrichtung (C) des Traggurts (6) und durch dessen Durchgangsöffnungen (63) hindurch aufweist.

11. Verpackungsanlage nach Anspruch 9 oder 10,
**dadurch gekennzeichnet, dass**
die Hubnadel (43) eine Hubrichtung (B) senkrecht zur Förderrichtung (C) des Traggurts (6) und bis zum unteren Rand von dessen Durchgangsöffnungen (63) aufweist.

12. Verpackungsanlage nach einem der Ansprüche 9 bis 11,
**dadurch gekennzeichnet, dass**
die Hubbewegungen der Vakuumpipette (42) und der Hubnadel (43) jeweils synchronisiert sind.

13. Verpackungsanlage nach einem der Ansprüche 9 bis 12,
**dadurch gekennzeichnet, dass**
die Vakuumpipette (42) eine waagrechte Bewegungskomponente in die gleiche Richtung wie die Förderrichtung (C) des Traggurts (6) aufweist.

14. Verpackungsanlage nach einem der Ansprüche 9 bis 13,
**dadurch gekennzeichnet, dass**
die Bauteile (10) in Zeilen und/oder in Spalten auf einem Bauteilträger bzw. einem Nutzen (8) aufgebracht sind und durch eine Trägerfolie (81) zusammen gehalten sind.

15. Verpackungsanlage nach Anspruch 14,
**dadurch gekennzeichnet, dass**
der Bauteilträger bzw. der Nutzen (8) mit der Trägerfolie (81) auf einem horizontal verschiebbaren Ablagetisch (22) aufgebracht ist.

16. Verpackungsanlage nach Anspruch 15,
**dadurch gekennzeichnet, dass**
der Ablagetisch (22) in einer ersten horizontalen Richtung parallel zur Förderrichtung (C) des Traggurtes (6) sowie in einer zweiten horizontalen Richtung senkrecht dazu verschiebbar ist.

17. Verpackungsanlage nach Ansprüche 15 oder 16,
**dadurch gekennzeichnet, dass**
der Ablagetisch (22) eine zweite Öffnung (24) größeren Durchmessers als die Hubnadel (43) aufweist, die jeweils in eine senkrecht unterhalb einer Durchgangsöffnung (63) des Traggurts (6) befindliche Position bringbar ist.

18. Verpackungsanlage nach einem der Ansprüche 9 bis 17,
**dadurch gekennzeichnet, dass**
die Führungsplatte (21) eine erste Öffnung (23) größeren Durchmessers als eine Grundfläche eines Bauteils (10) aufweist, durch die sich mittig die linearen Hubachsen der Vakuumpipette (42) sowie der Hubnadel (43) erstrecken.

19. Verpackungsanlage nach einem der Ansprüche 9 bis 18,
**dadurch gekennzeichnet, dass**
die Verpackungsanlage (2) eine Zuführvorrichtung (25) für die obere Abdeckfolie (64) in Förderrichtung (C) des Traggurtes (6) hinter der Aufnahmevorrichtung (41) aufweist.

20. Verpackungsanlage nach einem der Ansprüche 9 bis 19,
**dadurch gekennzeichnet, dass**
die Verpackungsanlage (2) eine Zuführvorrichtung (26) für die untere Abdeckfolie (65) in Förderrichtung (C) des Traggurtes (6) hinter der Aufnahmevorrichtung (41) aufweist.

21. Verpackungsanlage nach einem der Ansprüche 9 bis 20,
**dadurch gekennzeichnet, dass**
die Zuführvorrichtung (26) für die untere Abdeckfolie (65) in Förderrichtung (C) des Traggurtes (6) hinter der Zuführvorrichtung (25) für die obere Abdeckfolie (64) angeordnet ist.

22. Verpackungsanlage nach einem der Ansprüche 9 bis 21,
**dadurch gekennzeichnet, dass**
oberhalb der Zuführvorrichtung (26) für die untere Abdeckfolie (65) eine Vakuumsaugvorrichtung (27) zur Anhebung der elektronischen Bauteile (10) in ihren Durchgangsöffnungen (63) vorgesehen ist.

## Claims

1. Method of populating a carrier tape with components, which has the following steps:
- providing a carrier tape (6) with passage openings (63) for a packaging system (2) for populating the carrier tape (6) with components (10),
- picking up individual components (10) from a support table (22) arranged underneath a guide plate (21) of the packaging system (2) by means of a vacuum pipette (42), by the vacuum pipette (42) being moved through the passage opening (63) in the carrier tape (6),
- lifting the component (10) into one of the passage openings (63) in the carrier tape (6) by means of a vertical lifting movement of the vacuum pipette (42),
- wiping the component (10) off the vacuum pipette (42) by means of the carrier tape (6), by means of a movement of the carrier tape (6) in a horizontal conveying direction (C),
- picking up the component (10) and the carrier tape (6) between the guide plate (21) and the guide covering (29) arranged above the carrier tape (6) as they are wiped off the vacuum pipette (42) by means of an upper guide (31) of the guide covering (29) and by means of a lower guide (32) of the guide plate (21),
- closing an upper side (61) of the tape by applying an upper cover film (64),
- closing an upper side (62) of the tape by applying a lower cover film (65).

2. Method according to Claim 1, **characterized in that** the components (10) are lifted from below by a lifting needle (43).

3. Method according to Claim 1 or 2, **characterized in that** the vacuum pipette (42) and the lifting needle (43) carry out a vertical lifting movement through a first opening (23) in the guide plate (21).

4. Method according to one of Claims 1 to 3, **characterized in that** at least the vacuum pipette (42) carries out a horizontal movement in the conveying direction (C) of the carrier tape (6) as it inserts a component (10) into a passage opening (63) in the said carrier tape (6).

5. Method according to one of Claims 1 to 4,
**characterized in that** the lower cover film (65) is applied underneath a vacuum suction device (27), which prevents the components (10) falling out of the passage openings (63) in the carrier tape (6).

6. Method according to one of Claims 1 to 5, **characterized in** the upper and lower cover film (64, 65) are applied by means of a heating device (28) in an adhesive manner to the upper side (61) of the tape and to the underside (62) of the tape.

7. Method according to one of Claims 1 to 6, **characterized in that** the upper and the lower cover film (64, 65) are adhesively bonded to the upper side (61) and underside (62) of the tape.

8. Method according to one of Claims 1 to 8, **characterized in that** the carrier tape (6) used is a paper tape which has passage openings (63) to hold components (10).

9. Packaging system having a guide plate (21), which has a lower guide (32), and having a guide covering (29), which has an upper guide (31), for the linear guidance of a carrier tape (6) that can be populated with components (10), and having a support table (22) arranged underneath the guide plate (21) for semiconductor chips or semiconductor components to be packed, a passage opening (23) being provided in the guide plate (21) and the guide covering (29), and
- the packaging system (2) having a carrier tape populating tool (4) with a vacuum pipette (42) and a lifting needle (43),
- it being possible in each case for a lifting movement to be carried out by the vacuum pipette (42) and/or by the lifting needle (43),
- it being possible for the lifting needle (43) and/or the vacuum pipette (42) to be moved in and/or through the passage opening (23) in the guide plate (21),
- it being possible for the vacuum pipette (42) to carry out a lifting movement through the passage opening (23) in the guide plate (21), and
the packaging system (2) further having at least one upper cover film device for applying an upper cover film (64) and/or a lower cover film device for applying a lower cover film (65).

10. Packaging system according to Claim 9, **characterized in that** the vacuum pipette (42) has a lifting direction at right angles to the conveying direction (C) of the carrier tape (6) and through the passage openings (63) in the latter.

11. Packaging system according to Claim 9 or 10, **characterized in that** the lifting needle (43) has a lifting direction (B) at right angles to the conveying direction (C) of the carrier tape (6) and as far as the lower edge of the passage openings (63) in the latter.

12. Packaging system according to one of Claims 9 to 11, **characterized in that** the lifting movements of the vacuum pipette (42) and of the lifting needle (43) are in each case synchronised.

13. Packaging system according to one of Claims 9 to 12, **characterized in that** the vacuum pipette (42) has a horizontal movement component in the same direction as the conveying direction (C) of the carrier tape (6).

14. Packaging system according to one of Claims 9 to 13, **characterized in that** the components (10) are applied to a component carrier or a blank (8) in rows and/or in columns, and are held together by a carrier film (81).

15. Packaging system according to Claim 14, **characterized in that** the component carrier or the blank (8) with the carrier film (81) is applied to a support table (22) that can be displaced horizontally.

16. Packaging system according to Claim 15, **characterized in that** the support table (22) can be displaced in a first horizontal direction parallel to the conveying direction (C) of the carrier tape (C) and in a second horizontal direction at right angles thereto.

17. Packaging system according to Claim 15 or 16, **characterized in that** the support table (22) has a second opening (24) of greater diameter than the lifting needle (43), which can in each case be brought into a position located vertically underneath a passage opening (63) in the carrier tape (6).

18. Packaging system according to one of Claims 9 to 17, **characterized in that** the guide plate (21) has a first opening (23) of greater diameter than an outline of a component (10), through which opening the linear lifting axes of the vacuum pipette (42) and of the lifting needle (43) extend centrally.

19. Packaging system according to one of Claims 9 to 18, **characterized in that** the packaging system (2) has a feed device (25) for the upper cover film (64) behind the pick-up device (41) in the conveying direction (C) of the carrier tape (6).

20. Packaging system according to one of Claims 9 to 19, **characterized in that** the packaging system (2) has a feed device (26) for the lower cover film (65) behind the pick-up device (41) in the conveying direction (C) of the carrier tape (6).

21. Packaging system according to one of Claims 9 to 20, **characterized in that** the feed device (26) for the lower cover film (65) is arranged behind the feed device (25) for the upper cover film (64) in the conveying direction (C) of the carrier tape (6).

22. Packaging system according to one of Claims 9 to 21, **characterized in that** a vacuum suction device (27) is provided above the feed device (26) for the lower cover film (65), to raise the electronic components (10) into their passage openings (63).

## Revendications

1. Procédé pour implanter des composants sur une bande support, présentant les étapes suivantes :
- mise à disposition d'une bande support (6) avec des ouvertures de passage (63) pour un dispositif d'emballage (2) pour l'implantation de composants (10) sur la bande support (6),
- réception de composants individuels (10) d'une table de dépose (22) disposée en dessous d'une plaque de guidage (21) du dispositif d'emballage (2) au moyen d'une pipette à vide (42), en déplaçant la pipette à vide (42) à travers l'ouverture de passage (63) de la bande support (6),
- soulèvement du composant (10) dans l'une des ouvertures de passage (63) de la bande support (6) au moyen d'un déplacement de levage vertical de la pipette à vide (42),
- raclage du composant (10) de la pipette à vide (42) au moyen de la bande support (6), par un déplacement de la bande support (6) dans une direction d'avance horizontale (C),
- réception du composant (10) et de la bande support (6) entre la plaque de guidage (21) et le recouvrement de guidage (29) disposé au-dessus de la bande support (6) lors du raclage de la pipette à vide (42) au moyen d'un guide supérieur (31) du recouvrement de guidage (29) et d'un guide inférieur (32) de la plaque de guidage (21),
- fermeture d'un côté supérieur de la bande (61) en appliquant une feuille de recouvrement supérieure (64),
- fermeture d'un côté inférieur de la bande (62) en appliquant une feuille de recouvrement inférieure (65).

2. Procédé selon la revendication 1, **caractérisé en ce que** les composants (10) sont soulevés par le bas au moyen d'une aiguille de levage (43).

3. Procédé selon la revendication 1 ou 2, **caractérisé en ce que** la pipette à vide (42) et l'aiguille de levage (43) effectuent un déplacement de levage vertical à travers une première ouverture (23) de la plaque de guidage (21).

4. Procédé selon l'une quelconque des revendications 1 à 3, **caractérisé en ce qu'**au moins la pipette à vide (42) effectue un mouvement horizontal avec sa direction d'avance (C) lors de l'introduction d'un composant (10) dans une ouverture de passage (63) de la bande support (6).

5. Procédé selon l'une quelconque des revendications 1 à 4, **caractérisé en ce que** la feuille de recouvrement inférieure (65) est appliquée en dessous d'un dispositif d'aspiration à vide (27), qui empêche les composants (10) de tomber vers le bas hors des ouvertures de passage (63) de la bande support (6).

6. Procédé selon l'une quelconque des revendications 1 à 5, **caractérisé en ce que** la feuille de recouvrement supérieure et la feuille de recouvrement inférieure (64, 65) sont appliquées au moyen d'un dispositif de chauffage (28) par adhésion sur le côté supérieur de la bande (61), respectivement sur le côté inférieur de la bande (62).

7. Procédé selon l'une quelconque des revendications 1 à 6, **caractérisé en ce que** la feuille de recouvrement supérieure et la feuille de recouvrement inférieure (64, 65) sont collées au côté supérieur, respectivement inférieur (61, respectivement 62), de la bande.

8. Procédé selon l'une quelconque des revendications 1 à 8, **caractérisé en ce que** l'on utilise comme bande support (6) une bande de papier qui présente des ouvertures de passage (63) pour recevoir des composants (10).

9. Dispositif d'emballage comprenant une plaque de guidage (21), qui présente un guide inférieur (32), et un recouvrement de guidage (29), qui présente un guide supérieur (31), pour le guidage linéaire d'une bande support (6) sur laquelle peuvent être implantés des composants (10), et comprenant une table de dépose (22) disposée en dessous de la plaque de guidage (21) pour des puces de semiconducteurs ou des composants semiconducteurs à emballer, une ouverture de passage (23) étant prévue dans la plaque de guidage (21) et le recouvrement de guidage (29) et :
- le dispositif d'emballage (2) présentant un outil d'implantation sur la bande support (4) avec une pipette à vide (42) et une aiguille de levage (43),
- la pipette à vide (42) et/ou l'aiguille de levage (43) permettant d'effectuer un mouvement de levage respectif,
- l'aiguille de levage (43) et/ou la pipette à vide (42) pouvant être déplacée dans et/ou à travers l'ouverture de passage (23) de la plaque de guidage (21),
- la pipette à vide (42) pouvant effectuer un mouvement de levage à travers l'ouverture de passage (23) de la plaque de guidage (21), et
le dispositif d'emballage (2) présentant en outre au moins un dispositif de feuille de recouvrement supérieur pour appliquer une feuille de recouvrement supérieure (64) et/ou un dispositif de feuille de recouvrement inférieur pour appliquer une feuille de recouvrement inférieure (65).

10. Dispositif d'emballage selon la revendication 9, **caractérisé en ce que** la pipette à vide (42) présente une direction de levage perpendiculaire à la direction d'avance (C) de la bande support (6) et à travers ses ouvertures de passage (63).

11. Dispositif d'emballage selon la revendication 9 ou 10, **caractérisé en ce que** l'aiguille de levage (43) présente une direction de levage (B) perpendiculaire à la direction d'avance (C) de la bande support (6) et jusqu'au bord inférieur de ses ouvertures de passage (63).

12. Dispositif d'emballage selon l'une quelconque des revendications 9 à 11, **caractérisé en ce que** les mouvements de levage de la pipette à vide (42) et de l'aiguille de levage (43) sont respectivement synchronisés.

13. Dispositif d'emballage selon l'une quelconque des revendications 9 à 12, **caractérisé en ce que** la pipette à vide (42) présente une composante de déplacement horizontale dans la même direction que la direction d'avance (C) de la bande support (6).

14. Dispositif d'emballage selon l'une quelconque des revendications 9 à 13, **caractérisé en ce que** les composants (10) sont appliqués en lignes et/ou en colonnes sur un support de composants ou sur un flan (8) et sont maintenus ensemble par une feuille de support (81).

15. Dispositif d'emballage selon la revendication 14, **caractérisé en ce que** le support de composants ou le flan (8) est appliqué avec la feuille de support (81) sur une table de dépose (22) déplaçable horizontalement.

16. Dispositif d'emballage selon la revendication 15, **caractérisé en ce que** la table de dépose (22) peut être déplacée dans une première direction horizontale parallèle à la direction d'avance (C) de la bande support (6) ainsi que dans une deuxième direction horizontale perpendiculaire à celle-ci.

17. Dispositif d'emballage selon la revendication 15 ou 16, **caractérisé en ce que** la table de dépose (22) présente une deuxième ouverture (24) de plus grand diamètre que l'aiguille de levage qui peut être amenée à chaque fois dans une position verticale en dessous d'une ouverture de passage (63) de la bande support (6).

18. Dispositif d'emballage selon l'une quelconque des revendications 9 à 17, **caractérisé en ce que** la plaque de guidage (21) présente une première ouverture (23) de plus grand diamètre qu'une surface de base d'un composant (10), à travers laquelle s'étendent centralement les axes de levage linéaires de la pipette à vide (42) et de l'aiguille de levage (43).

19. Dispositif d'emballage selon l'une quelconque des revendications 9 à 18, **caractérisé en ce que** le dispositif d'emballage (2) présente un dispositif d'alimentation (25) pour la feuille de recouvrement supérieure (64) dans la direction d'avance (C) de la bande support (6) derrière le dispositif de réception (41).

20. Dispositif d'emballage selon l'une quelconque des revendications 9 à 19, **caractérisé en ce que** le dispositif d'emballage (2) présente un dispositif d'alimentation (26) pour la feuille de recouvrement inférieure (65) dans la direction d'avance (C) de la bande support (6) derrière le dispositif de réception (41).

21. Dispositif d'emballage selon l'une quelconque des revendications 9 à 20, **caractérisé en ce que** le dispositif d'alimentation (26) pour la feuille de recouvrement inférieure (65) dans la direction d'avance (C) de la bande support (6) est disposé derrière le dispositif d'alimentation (25) pour la feuille de recouvrement supérieure (64).

22. Dispositif d'emballage selon l'une quelconque des revendications 9 à 21, **caractérisé en ce que** l'on prévoit au-dessus du dispositif d'alimentation (26) pour la feuille de recouvrement inférieure (65) un dispositif d'aspiration à vide (27) pour soulever les composants électroniques (10) dans ses ouvertures de passage (63).
